Europäisches Patentamt

European Patent Office

Office européen des brevets

(19)

(11) Veröffentlichungsnummer: **0 183 925**
**B1**

(12) **EUROPÄISCHE PATENTSCHRIFT**

(45) Veröffentlichungstag der Patentschrift: **23.05.90**

(51) Int. Cl.⁵: **C 23 C 18/24**

(21) Anmeldenummer: **85111347.2**

(22) Anmeldetag: **07.09.85**

(54) Verfahren zum An- und Abätzen von Kunststoffschichten in Bohrungen von Basismaterial für Leiterplatten.

(30) Priorität: **05.10.84 DE 3437084**

(43) Veröffentlichungstag der Anmeldung:
**11.06.86 Patentblatt 86/24**

(45) Bekanntmachung des Hinweises auf die
Patenterteilung:
**23.05.90 Patentblatt 90/21**

(84) Benannte Vertragsstaaten:
**BE CH DE FR GB IT LI LU NL SE**

(56) Entgegenhaltungen:
**DE-A-1 694 724**
**DE-C-1 209 844**
**US-A-3 523 874**

(73) Patentinhaber: **SCHERING
AKTIENGESELLSCHAFT Berlin und Bergkamen
Müllerstrasse 170/178 Postfach 65 03 11
D-1000 Berlin 65 (DE)**

(72) Erfinder: **Grapentin, Hans-Joachim
Wundstrasse 17
D-1000 Berlin 19 (DE)**
Erfinder: **Schaar, Detlef
Röntgenstrasse 9
D-1000 Berlin 10 (DE)**

EP 0 183 925 B1

Courier Press, Leamington Spa, England.

## Beschreibung

Die Erfindung betrifft ein Verfahren zum zuverlässigen An- und Abätzen sowie Aufrauhen von Kunststoffschichten in den Bohrungen von Basismaterial für eine haftfeste Metallisierung von Leiterplatten gemäß Oberbegriff des Anspruchs 1.

Bei Bohren von Löchern in Kunststoffplatten, beispielsweise mit Epoxidharz imprägnierten Glasfaserplatten, verschmiert der Bohrer die Lochinnenwand, da sich das Material beim Bohrvorgang erhitzt und weich wird.

Gedruckte Schaltungen, die durch Löcher die beiden Oberflächen oder innerhalb der Isolierplatte nach dem Durchkontaktierungsprozeß elektrisch verbinden, sind in ihrer Funktionsfähigkeit der sogenannten Mehrlagenschaltung in hohem Maße davon abhängig, ob die beim Bohren der Löcher entstehenden Kunststoff-Schichtverschmierungen zuverlässig entfernt werden können.

Verfahren zur Entfernung dieser Verschmierungen sind bereits bekannt, wie zum Beispiel der Chromsäure- oder der Schwefelsäureätz-Prozeß.

Diese Verfahren arbeiten jedoch unbefriedigend, indem das stromlos abgeschiedene Kupfer an den Lochwandungen, besonders auf Harzzonen, schlecht haftet, was infolge mangelhafter Belegung zu einer fehlerhaften Durchkontaktierung führt.

Aus der DE-A-1694 724 ist andererseits bereits ein Ätzverfahren zum Aufrauhen von Kunststoffschichten bekannt, die anschließend an die Ätzung mit einer haftfesten Metallschicht versehen werden. Die Ätzlösung besteht hierin aus 7,6 1 $H_2SO_4$-konz., 3,8 1 $HNO_3$ konz., 28,3 ml HCl konz. und 0,95 1 $H_2O$. Eine Anregung, Kunststoff-Schichtverschmierungen aus den Bohrungen von Basismaterial zu entfernen, ist dieser Druckschrift nicht zu entnehmen.

Aufgabe der vorliegenden Erfindung ist die Schaffung eines Verfahrens der eingangs bezeichneten Art, welches sowohl eine zuverlässige Entfernung der in den Bohrungen von Basisplatten infolge des Bohrvorganges enthaltenen Kunststoff-Schichtverschmierungen als auch eine rißfreie Aufrauhung der Lochwandungen ermöglicht.

Diese Aufgabe wird erfindungsgemäß durch den im Anspruch 1 gekennzeichneten Gegenstand gelöst.

Vorteilhafte Weiterbildungen dieses Gegenstandes sind in den Unteransprüchen beschrieben.

Das erfindungsgemäße Verfahren bewirkt in bisher nicht erreichter Weise sowohl eine völlige Entfernung der Schichtverschmierung in den Lochinnenwandungen als auch eine ideale Mikroaufrauhung der Oberfläche dieser Wandungen.

Dies hat zur Folge, daß das nach anschließender Aktivierung und Reduzierung chemisch und galvanisch abgeschiedene Metall, zum Beispiel ein Metall der Gruppen I B und VIII, wie Kupfer, an den Lochwandungen besonders gut haftet, und hervorragend für eine Durchkontaktierung zum Aufbau des Leiterbildes geeignet ist.

Ein weiterer wesentlicher Vorteil liegt darin, daß die Ätzrate wesentlich erniedrigt werden kann.

Die Anwendung erfolgt in an sich bekannter Weise im Sprüh- oder Schwallverfahren, kann jedoch im Gegensatz zu den bekannten Verfahren vorteilhafterweise auch im Tauchverfahren durchgeführt werden.

Als konzentrierte Schwefelsäure wird vorzugsweise Schwefelsäure mit einem Gehalt an 92 bis 98 Gewichtsprozent $H_2SO_4$ eingesetzt.

Als Phosphorsäure wird vorzugsweise eine Säure mit einem Gehalt an 85 Gewichtsprozent $H_3PO_4$ verwendet.

Nitratinonen $NO^3$ sind in Form der Salpetersäure und/oder deren Salzen in der schwefelsauren Lösung enthalten, wobei als Salze der Salpetersäure Alkalinitrate, zum Beispiel Natrium-, Kalium-, Lithium- oder Ammoniumnitrat, oder Schwermetallnitrate, zum Beispiel Chrom- oder Eisennitrat, in Frage kommen.

Die Lösung enthält die gekennzeichneten Bestandteile zweckmäßigerweise in Konzentrationen von 9 bis 17 Mol/Liter Schwefelsäure (d = 1,84 g/ml) entsprechend 500 bis 950 ml/Liter, und 1,2 bis 1,4. $10^{-3}$ Mol/Liter $NO^3$. Anion entsprechend zum Beispiel 0,1 bis 120 g/l Natriumnitrat. Phosphorsäure ist in Konzentrationen von 0,7 bis 7,4 Mol/Liter entsprechend 50 bis 500 ml/l $H_3PO_4$ (d = 1,71 g/ml) enthalten.

Von Vorteil ist es, der erfindungsgemäßen Lösung Flußsäure sowie gegebenenfalls ein Netzmittel, vorzugsweise einen fluorierten Kohlenwasserstoff, hinzuzusetzen, zweckmäßigerweise in Konzentrationen von 0,01 g bis 0,5 g/l. Als vorteilhaft hat sich weiterhin ein Zusatz von Alkaliphosphaten erwiesen.

Es versteht sich, daß das erfindungsgemäße Verfahren auch zum An- und Abätzen sowie Aufrauhen der Kunststoffschicht auf der Oberfläche von Basismaterial geeignet ist.

Die Behandlung erfolgt in der Regel bei Raumtemperaturen von 20 bis 45°C, vorzugsweise bei 25 bis 40°C, und kann je nach gewünschtem Effekt zwischen etwa 2 bis 5 Minuten betragen, wobei höhere oder niedrigere Einwirkungszeiten bei Bedarf möglich sind.

So kann beispielsweise durch Variation der Konzentrationen und der Einwirkungszeiten eine Anätzung von weniger als 10 µm Oberflächenschicht (sogenanntes Desmearing) und eine Rükkätzung von mehr als 10 µm Oberschicht (sogenanntes Etch-Back) durchgeführt werden.

Als Basismaterial eignet sich insbesondere glasfaserverstärktes Epoxidharz, jedoch können auch alle anderen gebräuchlichen Materialien, wie nichtbeschichtetes Basismaterial, Phenolharzpapier, Epoxidharzpapier, Plexiglas, Polysulfon, Polyimid, Polyamid, Polyphenylenoxyd-Polysterol, Fluorkohlenwasserstoff, Polycarbonate, Polyätherimid oder als beschichtetes Basismaterial ein Träger, dessen Oberfläche mit einer festhaftenden, durch Wärme aushärtbaren Schicht versehen ist, die mindestens einen Stoff enthält, der der Gruppe der modifizierten Gummi bzw. Kunstgummi angehört und durch geeignete Oxydationsmittel oxydierbar bzw. abbaubar ist, oder als Baismaterial ein Träger, dessen Oberfläche mit einem Metall, vorzugsweise Kupfer, ein- oder beidseitig beschichtet ist, verwendet werden.

Die einzelnen Behandlungsschritte bis zur Ausführung der Bohrungen und erfolgter erfindungsgemäßer Behandlung durchgeführten Weiterbehandlung, wie Spülvorgänge, das Aktivieren und das chemische und gegebenenfalls galvanische Metallisieren sind an sich bereits bekannt und können vom Fachmann je nach Aufgabenstellung im wesentlichen unverändert durchgeführt werden.

Das erfindungsgemäße Verfahren eignet sich sowohl für die Semi- als auch die Subtraktivtechnik zur Herstellung von gedruckten Schaltungen.

Die folgenden Beispiele dienen zur Erläuterung des erfindungsgemäßen Verfahrens.

### Beispiel 1
Ein beidseitig mit Kupfer beschichtetes Basismaterial aus glasfaserverstärktem Epoxydharz wird in üblicher Weise gebohrt und entgratet.

Anschließend wird die derart behandelte Platte in eine Lösung der Zusammensetzung

850 ml Schwefelsäure (96 Gewichtsprozentig)
150 ml Phosphorsäure (85 Gewichtsprozentig)
1 g Natriumnitrat
1 bis 5 Minuten bei einer Temperatur von 25 bis 40°C getaucht.

Nach dem Abtropfen, Spülen, alkalischer Nachreinigung, Behandlung mit salzsaurer Ammoniumfluorid-Lösung und weiterer üblicher Nachbehandlung wird aktiviert und chemisch mit einer Schichtdicke von 0,2 µm oder von 3 µm verkupfert.

Die Kupferschicht ist blasenfrei und zeigt ausgezeichnete Haftung, ist lötbeständig (Lötbeständigkeitstest 3 × 5 sec. bei 260°C). Die Anätzung (Ätzrate) ist hierbei größer als 10 µm (Etch-Back).

### Beispiel 2
Analog Beispiel 1 wird eine Platte unter Verwendung einer Lösung der Zusammensetzung

850 ml Schwefelsäure (96 Gewichtsprozentig)
150 ml Phosphorsäure (85 Gewichtsprozentig)
10 g Natriumnitrat

behandelt.
Die abgeschiedene Kupferschicht weist dieselben hervorragenden Eigenschaften auf, wie im Beispiel 1 beschrieben.

### Beispiel 3
Analog Beispiel 1 wird eine Platte unter Verwendung einer Lösung der Zusammensetzung

850 ml Schwefelsäure (96 Gewichtsprozentig)
150 ml Phosphorsäure (85 Gewichtsprozentig)
10 g Kaliumnitrat

behandelt.
Die abgeschiedene Kupferschicht weist dieselben hervorragenden Eigenschaften auf, wie im Beispiel 1 beschrieben.

### Beispiel 4
Analog Beispiel 1 wird eine Platte unter Verwendung einer Lösung der Zusammensetzung

850 ml Schwefelsäure (96 Gewichtsprozentig)
150 ml Phosphorsäure (85 Gewichtsprozentig)
10 g Ammoniumnitrat

behandelt.
Die abgeschiedene Kupferschicht weist dieselben hervorragenden Eigenschaften auf, wie im Beispiel 1 beschrieben.

### Beispiel 5
Analog Beispiel 1 wird eine Platte unter Verwendung einer Lösung der Zusammensetzung

850 ml Schwefelsäure (96 Gewichtsprozentig)
150 ml Phosphorsäure (85 Gewichtsprozentig)
10 g Chrom(III)nitrat

behandelt.
Die abgeschiedene Kupferschicht weist dieselben hervorragenden Eigenschaften auf, wie in Beispiel 1 beschrieben.

### Beispiel 6
Analog Beispiel 1 wird eine Platte unter Verwendung einer Lösung der Zusammensetzung

850 ml Schwefelsäure (96 Gewichtsprozentig)
150 ml Phosphorsäure (85 Gewichtsprozentig.)
1 g Natriumnitrat
0,05 g Netzmittel (fluorierter Kohlenwasserstoff)
behandelt.

Die abgewchiedene Kupferschicht weist dieselben hervorragenden Eigenschaften auf, wie im Beispiel 1 beschrieben.

### Beispiel 7
Die in den Beispielen 1 bis 6 beschriebenen Verfahren werden wiederholt mit einer Tauchzeit von 20 bis 60 Sekunden.

Es erfolgt hierbei eine Anätzung (Ätzrate) von weniger als 10 µm (Desmearing), die Kupferschichten weisen dieselben hervorragenden Eigenschaften auf, wie im Beispiel 1 beschrieben.

### Beispiel 8
Ein beidseitig mit Kupfer beschichtetes Basismaterial aus glasfaserverstärktem Epoxydharz wird in üblicher Weise gebohrt und entgratet.

Anschließend wird die derart behandelte Platte in eine Lösung der Zusammensetzung

1000 ml Schwefelsäure (96 Gewichtsprozentig)
1 g Natriumnitrat
20 bis 60 Sekunden bei einer Temperatur von 25 bis 40°C getaucht.

Nach dem Abtropfen, Spülen, alkalischer Nachreinigung, Behandlung mit salzsaurer Ammoniumbifluorid Lösung und weiterer üblicher Nachbehandlung wird aktiviert und chemisch mit einer Schichtdicke von 0,2 µm oder 3 µm verkupfert.

Die Kupferschicht ist blasenfrei und zeigt ausgezeichnete Haftung, ist lötbeständig (Lötbeständigkeitstest 3 x 5 sec. bei 260°C). Die Anätzung (Ätzrate) ist hierbei größer als 10 µm (Etch-Back).

### Beispiel 9

Analog Beispiel 8 wird eine Platte unter Verwendung einer Lösung der Zusammensetzung

1000 ml Schwefelsäure (96 Gewichtsprozentig)
10 g Natriumnitrat

behandelt.

Die abgeschiedene Kupferschicht weist dieselben hervorragenden Eigenschaften auf, wie in Beispiel 8 beschrieben.

### Beispiel 10

Analog Beispiel 8 wird eine Platte unter Verwendung einer Lösung der Zusammensetzung

1000 ml Schwefelsäure (96 Gewichtsprozentig)
10 g Kaliumnitrat

behandelt.

Die abgeschiedene Kupferschicht weist dieselben hervorragenden Eigenschaften auf, wie im Beispiel 8 beschrieben.

### Beispiel 11

Analog Beispiel 8 wird eine Platte unter Verwendung einer Lösung der Zusammensetzung

1000 ml Schwefelsäure (96 Gewichtsprozentig)
10 g Ammoniumnitrat

behandelt.

Die abgeschiedene Kupferschicht weist dieselben hervorragenden Eigenschaften auf, wie im Beispiel 8 beschrieben.

### Beispiel 12

Analog Beispiel 8 wird eine Platte unter Verwendung einer Lösung der Zusammensetzung

1000 ml Schwefelsäure (96 Gewichtsprozentig)
10 g Chrom(III)nitrat

behandelt.

Die abgeschiedene Kupferschicht weist dieselben hervorragenden Eigenschaften auf, wie in Beispiel 8 beschrieben.

### Beispiel 13

Analog Beispiel 8 wird eine Platte unter Verwendung einer Lösung der Zusammensetzung

1000 ml Schwefelsäure (96 Gewichtsprozentig)
1 g Chrom(III)nitrat

behandelt.

Die abgeschiedene Kupferschicht weist dieselben hervorragenden Eigenschaften auf, wie in Beispiel 8 beschrieben.

### Beispiel 14

Analog Beispiel 8 wird eine Platte unter Verwendung einer Lösung der Zusammensetzung

1000 ml Schwefelsäure (96 Gewichtsprozentig)
1 g Natriumnitrat
0,05 g Netzmittel (fluorierter Kohlenwasserstoff)

behandelt.

Die abgeschiedene Kupferschicht weist dieselben hervorragenden Eigenschaften auf, wie in Beispiel 8 beschrieben.

**Patentansprüche**

1. Verfahren zu zuverlässigen An- und Abätzen sowie rißfreiem Aufrauhen von Kunststoffschichten in den Bohrungen von Basismaterial für eine haftfeste Metallisierung von Leiterplatten unter Verwendung von Schwefelsäure-Lösungen, dadurch gekennzeichnet, daß die Bohrungen mit einer Lösung behandelt werden, die aus 9 bis 17 Mol/Liter Schwefelsäure und 1,2 bis 1,4. $10^{-3}$ Mol/Liter Nitratanionen und gegebenenfalls 0,7-7,4 Mol/Liter Phosphorsäure und/oder Flußsäurezusätze und gegebenenfalls 0,01 bis 0,5 g/Liter Netzmittelzusatz besteht.

2. Verfahren gemäß Anspruch 1, dadurch gekennzeichnet, daß die Nitratanionen durch Salpetersäure und/oder den Salzen der Salpetersäure gebildet werden.

3. Verfahren gemäß Anspruch 1, dadurch gekennzeichnet, daß es sich um konzentrierte Schwefelsäure mit einem Gehalt an 92 bis 98 Gewichtsprozent $H_2SO_4$ handelt.

4. Verfahren gemäß Anspruch 1, dadurch gekennzeichnet, daß es sich um Phosphorsäure mit einem Gehalt an 85 Gewichtsprozent $H_3PO_4$ handelt.

5. Verfahren gemäß Anspruch 1, dadurch gekennzeichnet, daß das Netzmittel ein fluorierter Kohlenwasserstoff ist.

6. Verfahren gemäß Anspruch 1, dadurch gekennzeichnet, daß die Behandlung bei Temperaturen von 20 bis 45°C, vorzugsweise bei 25 bis 40°C erfolgt.

7. Verfahren gemäß Anspruch 1, dadurch gekennzeichnet, daß als Basismaterial glasfaserverstärktes Epoxidharz, Phenolharzpapier, Epoxidharzpapier, Plexiglas, Polysulfon, Polyimid, Polyamid, Polyphenylenoxyd-Polysterol, Fluorkohlenwasserstoff, Polycarbonate oder Polyätherimid, verwendet wird.

8. Verfahren gemäß Anspruch 1, dadurch gekennzeichnet, daß ein nichtbeschichtetes oder ein beschichtetes Basismaterial eingesetzt wird.

9. Verfahren gemäß Anspruch 8, dadurch gekennzeichnet, daß als beschichtetes Basismaterial ein Träger verwendet wird, dessen Oberfläche mit einer festhaftenden, durch Wärme aushärtbaren Schicht versehen ist, die mindestens einen Stoff enthält, der der Gruppe der modifizierten Gummi bzw. Kunstgummi angehört und durch geeignete Oxydationsmittel oxydierbar bzw. abbaubar ist.

10. Verfahren gemäß Anspruch 1, dadurch gekennzeichnet, daß als Basismaterial ein Träger verwendet wird, dessen Oberfläche mit Kupfer ein- oder beidseitig beschichtet ist.

11. Verfahren gemäß Anspruch 1, dadurch gekennzeichnet, daß das Basismaterial nach erfolgter An- und Abätzung der Bohrungen in an sich bekannter Weise aktiviert, reduziert sowie metallisiert wird.

## Revendications

1. Procédé pour corroder, décaper et granuler sans craquelures et fiablement les couches plastiques dans les forures de supports isolants pour une métallisation adhérente de cartes imprimées en utilisant des solutions d'acide sulfurique, ledit procédé étant caractérisé par le fait que les forures sont traitées au moyen d'une solution constituée de 9 à 17 mol/litre d'acide sulfurique et de 1,2 à 1,4. $10^{-3}$ mol/litre d'anions nitrates ainsi que, le cas échéant, de 0,7 à 7,4 mol/litre d'acide phosphorique et/ou d'additifs d'acide fluorhydrique ainsi que, le cas échéant, de 0,01 à 0,5 g/litre d'additif d'agent mouillant.

2. Procédé selon revendication 1, caractérisé en ce que les anions nitrates sont formés par de l'acide nitrique et/ou les sels de l'acide nitrique.

3. Procédé selon revendication 1, caractérisé en ce qu'il s'agit d'acide sulfurique concentré d'une teneur en $H_2SO_4$ de 92 à 98% en poids.

4. Procédé selon revendication 1, caractérisé en ce qu'il s'agit d'acide phosphorique d'une teneur en $H_3PO_4$ de 85% en poids.

5. Procédé selon revendication 1, caractérisé en ce que l'agent mouillant est un hydrocarbure fluoré.

6. Procédé selon revendication 1, caractérisé en ce que le traitement s'effectue à des températures comprises entre 20 et 45°C, et de préférence entre 25 et 40°C.

7. Procédé selon revendication 1, caractérisé en ce que de la résine époxy armée aux fibres de verre, du papier résine phénoplaste, du papier résine époxy, du plexiglas, du polysulfone, du polyimide, du polyamide, de polystryrène à l'oxyde de polyphénylène, de l'hydrocarbure fluoré, des polycarbonates ou du polyétherimide est utilisé pour le support isolant.

8. Procédé selon revendication 1, caractérisé en ce que le support isolant peut être plaqué ou non.

9. Procédé selon revendication 8, caractérisé en ce que l'on utilise comme support isolant plaqué un support dont la surface est pourvue d'une couche thermodurcissable adhérente dont au moins l'une des substances appartient au groupe des caoutchoucs modifiés ou des caoutchoucs synthétiques et peut être oxydée ou dégradée par un oxydant approprié.

10. Procédé selon revendication 1, étant caractérisé en ce que le support utilisé pour le support isolant est plaqué au cuivre sur l'une de ses faces ou sur les deux.

11. Procédé selon revendication 1, caractérisé en ce que le support isolant est activé, réduit et métallisé selon une méthode connue en soi une fois le décapage et la corrosion des forures effectuées.

## Claims

1. Method for reliable etching and corroding as well as crack-free roughening of plastic coatings in the drilled holes of base material for adhesive metal-plating of printed circuit boards using sulfuric acid solutions, characterized in that the holes are treated with a solution that consists of 9 to 17 mol/liter sulfuric acid and 1.2 to 1.4. $10^{-3}$ mol/liter nitrate anions and, as the case may be, 0.7-7.4 mol/liter phosphoric acid and/or hydrofluoric acid additives and, as the case may be, 0.01 to 0.5 g/liter wetting-agent additive.

2. Method in accordance with Claim 1, characterized in that the nitrate anions are formed by nitric acid and/or the salts of nitric acid.

3. Method in accordance with Claim 1, characterized in that concentrated sulfuric acid with a content of 92 to 98 percent $H_2SO_4$ by weight is involved.

4. Method in accordance with Claim 1, characterized in that phosphoric acid with a content of 85 percent $H_3PO_4$ by weight is involved.

5. Method in accordance with Claim 1, characterized in that the wetting agent is a fluorinated hydrocarbon.

6. Method in accordance with Claim 1, characterized in that the treatment takes place at temperatures of 20 to 45°C, preferably 25 to 40°C.

7. Method in accordance with Claim 1, characterized in that the base material used is glass-fiber-reinforced epoxy resin, phenolic resin paper, epoxy resin paper, plexiglas, polysulfone, polyimide, polyamide, polyphenylene oxide polystyrene, fluorocarbon, polycarbonate or polyether imide.

8. Method in accordance with Claim 1, characterized in that a non-coated or a coated base material is used.

9. Method in accordance with Claim 8, characterized in that the coated base material used is a substrate whose surface is provided with a firmly adhesive, heat-hardened layer that contains at least one substance that belongs to the group comprised of modified rubber respectively artificial rubber and which can be oxidized or decomposed with suitable oxidants.

10. Method in accordance with Claim 1, characterized in that the base material used is a substrate whose surface is coated with copper on one or both sides.

11. Method in accordance with Claim 1, characterized in that after corroding and etching of the holes the base material is activated in the way known as such, reduced and metal-plated.